# EUROPEAN PATENT APPLICATION

(11) **EP 0 613 180 A2**
(43) Date of publication of application: **31.08.1994**
(21) Application number: 94108007.9
(22) Date of filing: 07.05.1986
(51) Int. Cl.: H01L 23/48, H01L 29/40

(54) **Semiconductor device having wiring electrodes**

(30) Priority: 13.05.1985 JP 100915/85; 05.09.1985 JP 196503/85
(62) Divisional of application: 86106245.3
(71) Applicant: KABUSHIKI KAISHA TOSHIBA, Kawasaki-shi, Kanagawa-ken 210 (JP)
(72) Inventor: Maeda, Takeo, c/o Patent Division K. K. Toshiba, Tokyo 105 (JP)
(74) Representative: Lehn, Werner, Dipl.-Ing.

(57) **Abstract**

A semiconductor device of the invention has a p⁺-type silicon source region (24B), an insulating film (28, 18) formed on the source region (24B) and having a contact hole, and a wiring electrode (38B) connected to the source region (24B) through the contact hole. The wiring electrode (38B) has a Ti layer (32) formed on the insulating film and an exposed surface of the source region (24B), a TiN layer (34) formed on the Ti layer (32), and an Aℓ layer (36) formed on the TiN layer (34).

## Description

The present invention relates to a semiconductor device having wiring electrodes and, more particularly, to a semiconductor device wired through contact holes.

In semiconductor devices such as MOS transistors, aluminum is used as a wiring layer. A MOS transistor has, for example, n-type diffusion regions in the surface area of a p-type silicon substrate. These regions are used as a source and drain. Contact holes are formed by patterning an insulating layer covering the substrate and diffusion layers. Wiring layers are formed, extending through the contact holes and contacting the diffusion layers. In connecting the wiring layer with the diffusion layer, Aℓ is deposited on the diffusion layer by sputtering, and alloyed with Si by annealing.

However, when the wiring layer is heated to a temperature of 450°C in another step, the Aℓ diffuses from the wiring layer into the silicon substrate, growing Aℓ-Si spikes within the substrate. In recent years, shallow diffusion layers are often formed with a use of BF₂ and BCℓ₂, and, in this case, the alloy spikes may grow deeper than the diffusion layer. If spikes penetrate the diffusion layer and reach the substrate, the pn junction between the substrate and the diffusion layer will break down.

Furthermore, disconnection of the wiring layer occurs easily in the portion inside of the contact hole. This is because electromigration occurs in this portion when a relatively large current flows in the Aℓ wiring layer.

Two conventional methods of preventing alloy spikes are known. In the first method, Aℓ is deposited by sputtering, together with about 1 to 5% of Si (based on Aℓ amount), onto the diffusion layer. This method can reliably prevent alloy spikes. However, it would only be used when an increase in contact resistance can be ignored. In practice, such an increase in contact resistance cannot be ignored, and the Si amount must be reduced to a low percentage at which alloy spikes can not be sufficiently prevented. Namely, a high amount of silicon is preferable in the control of alloy spike growth. If the Si amount exceeds the solid solubility of Aℓ, however, solid Si precipitates in the wiring layer in addition to the Aℓ-Si alloy. The precipitated Si has a remarkably low conductivity. The contact resistance of the wiring layer undesirably increases due to the low conductivity. In particular, the narrow region of the wiring layer inside of the contact hole may be electrically separated from the diffusion region due to the precipitated Si. In addition, Aℓ and Si may not always be deposited at a uniform ratio during sputtering. As a result, even if the Si amount is within the solid solubility of Aℓ, Si will precipitate in a portion of the wiring layer.

In the second conventional method, a barrier metal layer, such as a TiN layer, is formed between the diffusion layer and the Aℓ layer. When the barrier metal is TiN, the boron (B) contained in the diffusion layer diffuses into the TiN layer, making it impossible to obtain good ohmic contact.

### Summary of the Invention

It is an object of the present invention to provide a semiconductor device which prevents alloy spikes without increasing the contact resistance of a wiring layer and offers good resistance against electromigration.

According to the invention, there is provided a semiconductor device comprising: a semiconductor element; an insulating film formed on the semiconductor element and having a contact hole which exposes a portion of this element; and a wiring electrode formed on the insulating film, extending through the contact hole, and contacting the semiconductor element, the electrode having a first layer of Ti formed on the insulating film and the exposed portion of the semiconductor element, a second layer of TiN formed on the first layer, and a third layer having Aℓ as a major component and formed on the second layer.

According to the device of this invention, the first and second layers are provided between the third layer and semiconductor element. The second layer acts as a barrier metal to block Aℓ diffusion along grain boundaries in the third layer, thus preventing occurrence of alloy spikes. The first layer maintains a low contact resistance between the wiring layer and the semiconductor element. The first and second layers, having high resistance to electromigration, will constitute a current path even if the third layer disappears due to electromigration.

### Brief Description of the Drawings

Figs. 1A to 1F show steps in the manufacture of a CMOS transistor according to a first embodiment of the present invention;
Fig. 2 is a graph for explaining the relationship between contact resistance and contact hole size;
Figs. 3A and 3B are diagrams for explaining steps in the manufacture of a CMOS transistor according to a second embodiment of the present invention;

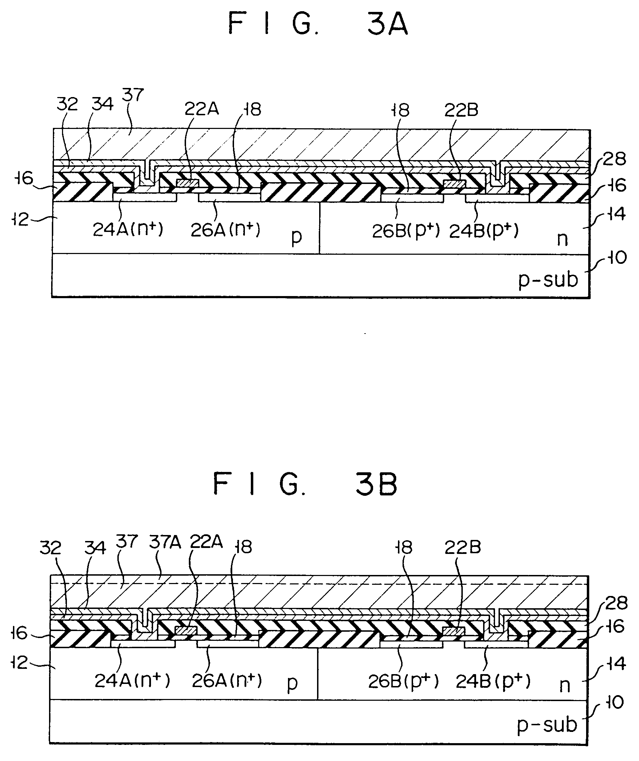

Fig. 4 shows a CMOS transistor having a Ti 50 layer according to a third embodiment of the present invention; and
Fig. 5 shows a CMOS transistor having a TiSi layer 52 according to a fourth embodiment of the present invention.

### Detailed Description of the Preferred Embodiments

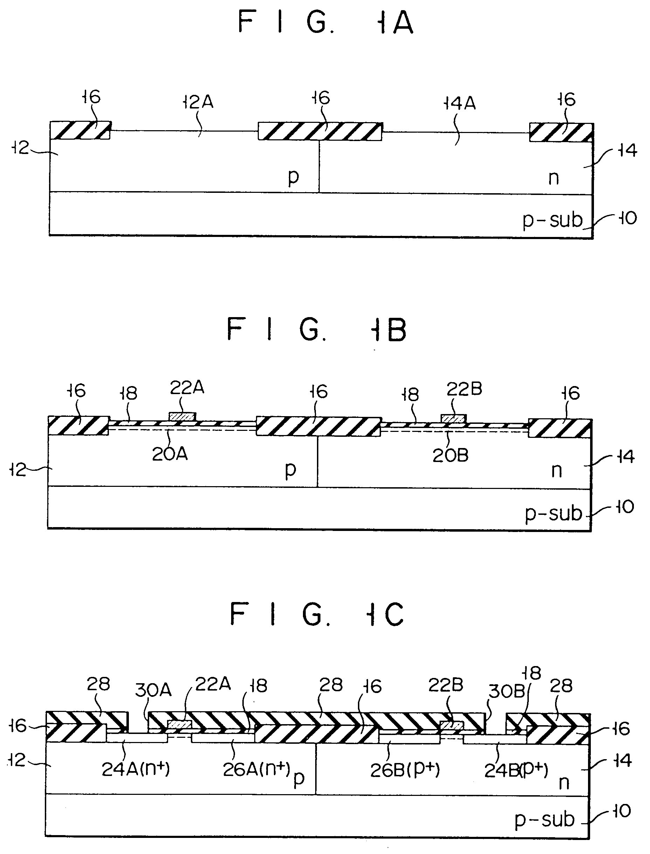

A semiconductor device according to a first embodiment of the present invention will be described with reference to Figs. 1A to 1F. Figs. 1A to 1F show steps in the manufacture of a CMOS transistor. In the first step, p-type silicon substrate 10 is prepared. p-type well 12 and n-type well 14 are formed in the surface area of substrate 10, as shown in Fig. 1A. Field oxide film 16 is formed to surround portions 12A and 14A of wells 12 and 14, which serve as element regions, as shown in Fig. 1A. The surfaces of element regions 12A and 14A are completely covered by gate oxide film 18, as shown in Fig. 1B. Channel implantation processing is then performed to set the threshold voltage of the transistor. This results in the formation of ion implantation layers 20A and 20B in regions 12A and 14A. A polycrystalline silicon layer (not shown) is formed on films 16 and 18 by deposition, doped with a predetermined amount of an impurity, and patterned. The remaining polycrystalline silicon constitutes gate electrodes 22A and 22B, as shown in Fig. 1B. An n-type impurity (e.g., P or As) and a p-type impurity (e.g., B, BF₂, or BCℓ₂) are ion-implanted in wells 12 and 14 in separate steps, using electrodes 22A and 22B as masks. Substrate 10 is then annealed, forming n⁺-type source and drain regions 24A and 26A in the surface area of well 12, and forming p⁺-type source and drain regions 24B and 26B in the surface area of well 14, as shown in Fig. 1C. Films 16 and 18 and electrodes 22A and 22B are covered by interlayer insulating film 28. Films 28 and 18 are patterned to form contact holes 30A and 30B, as shown in Fig. 1C. Contact holes 30A and 30B expose the corresponding portions of regions 24A and 24B.

Ti layer 32 and TiN layer 34 shown in Fig. 1D are successively formed in the same vacuum chamber by sputtering. In this step, Ti is deposited to a thickness of 50 nm on film 28 and on the exposed surfaces of source regions 24A and 24B. TiN is then deposited to a thickness of 50 nm on top of the Ti. An RF bias is applied to substrate 10 during the deposition of TiN to provide good crystallinity in the portion of contact between Ti layer 32 and TiN layer 34 and good step coverage. After layer 34 is formed, pure aluminum is deposited on layer 34 in the same vacuum chamber, forming Aℓ layer 36, as shown in Fig. 1D. The multi-layer structure of layers 36, 34, and 32 is patterned by photoetching and reactive ion etching, as shown in Fig. 1E. Remaining structures 38A and 38B are used as wiring electrodes for source regions 24A and 24B. In the patterning step, a gas mixture of BCℓ₃, Cℓ₂ and He is used as the etchant. Wiring electrodes 38A and 38B and film 28 are completely covered by SiO₂ layer 40. Layer 40 is formed by a low-temperature plasma CVD method, and is patterned to form contact hole 42 on layer 36, as shown in Fig. 1F. Aℓ layer 44, also shown in Fig. 1F, is formed by the same method and connected to layer 36. This completes the preparation of a CMOS transistor. In this transistor, electrodes 38A and 38B are used as a first-stage wiring layer, and layer 44 is used as a second-stage wiring layer. In this embodiment, wiring of the drain and control gate is formed just as described above, and has hence been omitted for the sake of brevity.

In the embodiment described above, Ti and TiN layers 32 and 34 are provided between Aℓ layer 36 and source regions 24A and 24B. TiN layer 34 acts as a barrier metal to block Aℓ diffusion along grain boundaries in Aℓ layer 36, thus preventing the growth of alloy spikes. As a result, the pn junctions between source region 24A and well 12 and between source region 24B and well 14 do not break down. Ti layer 32, in addition to preventing the boron in p⁺-type source region 24B from diffusing into layer 34, also maintains a low contact resistance between electrodes 38A and 38B and corresponding regions 24A and 24B. Ti and TiN layers 32 and 34, having high resistance to electromigration, will constitute a current path even if Aℓ layer 36 disappears due to electromigration. As a result, a complete failure in transistor functions cannot occur. Since TiN layer 34 has a thickness sufficient to prevent the growth of alloy spikes, Aℓ layer 36 need not contain Si. Thus, silicon does not precipitate in electrodes 38A and 38B, and the problem caused by Si precipitation in the portions of electrodes 38A and 38B inside of the contact holes can be avoided.

An experiment verified that good contact characteristics are obtained between electrode 38A and source region 24A and between electrode 38B and source region 24B. In this experiment, Ti layer 32 was sintered at 450°C for 15 minutes, and contact resistance was measured. The Ti was satisfactorily changed into TiSi by the sintering process, demonstrating that good contact characteristics can be obtained.

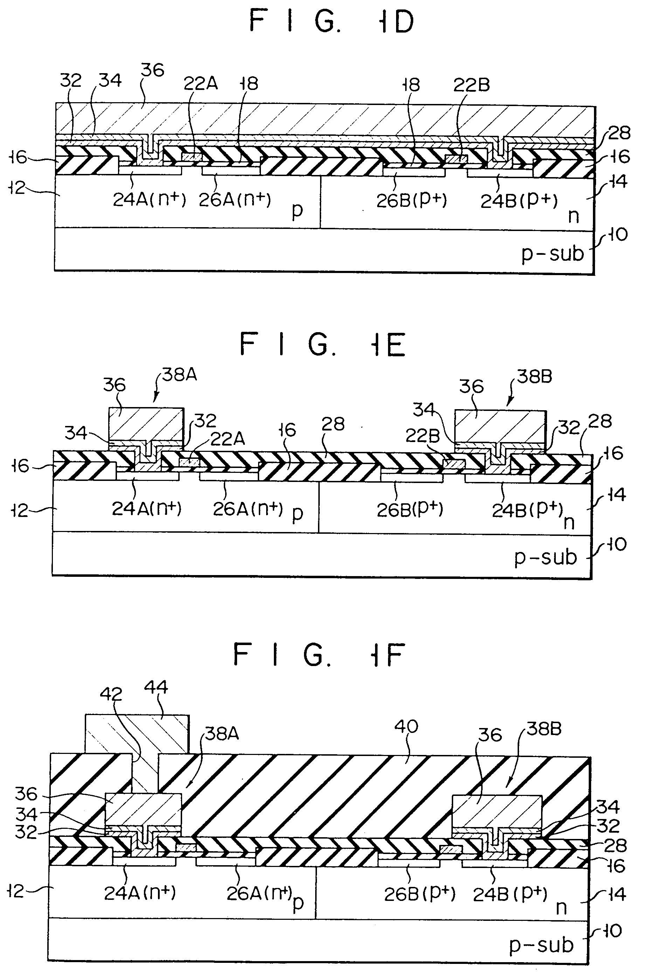

Fig. 2 shows the relationship between contact resistance and contact hole size. Curves (A) and (B) in Fig. 2 show the case where TiN is connected by a conventional technique to p⁺-type and n⁺-type silicon, respectively. Curves (C) and (D) show the case where Ti is connected to p⁺-type and n⁺-type silicon, respectively, according to the embodiment described above. As can be seen from the graph, there is no drastic increase in contact resistance with the devices according to the embodiment, even when contact hole size is reduced. Ti and p⁺-type silicon (i.e., Ti layer 32 and source region 24B) particularly experience larger reductions in contact resistance than in the conventional method.

In the above embodiment, pure aluminum layer 36 is used. The present invention, however, is not limited to this. The layer 36 can be replaced by one alloy selected from Aℓ-Si, Aℓ-Ti-Si, Aℓ-Zr-Si, Aℓ-Ti, and Aℓ-Zr. When an alloy layer containing Ti or Zr is used, Aℓ electromigration and Aℓ hillocks are prevented. When an alloy layer containing Si is used, the resistance of the alloy layer and the boron-doped diffusion layer are sufficiently kept low. In addition, openings in the wiring are prevented.

It is also possible to change the manufacturing steps for the CMOS transistor described above in the following manner. After forming layers 32 and 34 with sputtering in the same vacuum chamber, as shown in Fig. 1D, the semiconductor structure is annealed at 600°C for 30 minutes in a nitrogen atmosphere. This insures the complete transformation to TiN of the Ti grains in layer 34.

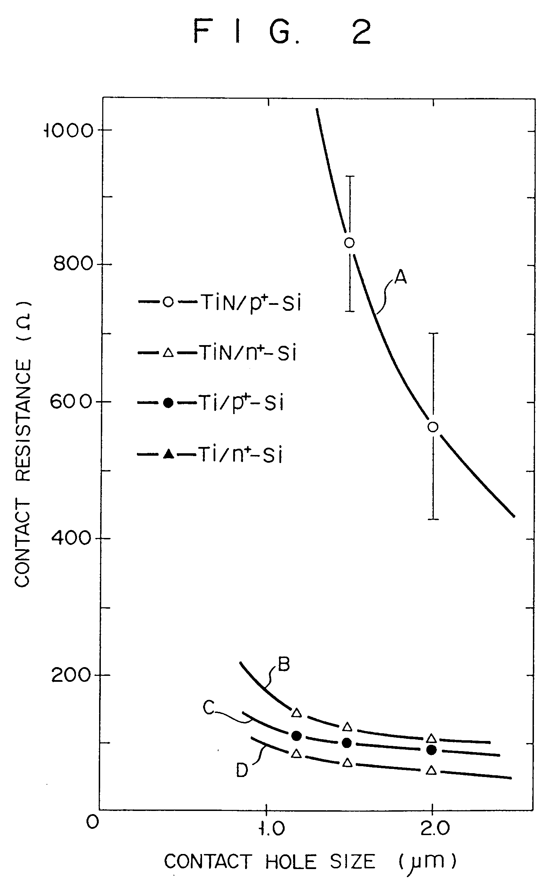

After annealing, Aℓ-Si alloy layer 37 is formed on layer 34, as shown in Fig. 3A. Argon (Ar), for example, is then ion-implanted in the surface area of layer 37 at a dose of 5 x 10¹⁵ cm⁻² and an acceleration voltage of 30 keV. This causes the portion of layer 37 as extending to the dashed line (Fig. 3) to become amorphous. The remaining steps are the same as the steps above described.

When TiN layer 34 is annealed in a nitrogen atmosphere as described above, Ti in layer 34 becomes a nitride. This serves to control so that an Aℓ-Si-Ti three-element alloy is not formed. Aℓ-Si alloy layer 37 prevents alloy spikes, even if layer 34 has pinholes. Furthermore, since the surface crystal of layer 37 is broken through the Ar ion-implantation, the Aℓ in layer 37 does not migrate along grain boundaries during the formation of layer 44. Thus, the generation of hillocks, electromigration, and thermal migration are prevented. With the device, the wiring is hardly be disconnected along Aℓ grain boundaries. The amorphous portion of layer 37 absorbs stress when the layer 44 is formed.

In addition, layer 37 may be replaced with Aℓ layer 36.

In Figs. 3A and 3B above, wiring electrodes 38A and 38B have a 3-layer structure of Aℓ alloy layer 37 (or Aℓ layer 36), TiN layer 34, and Ti layer 32. The electrodes may also have a Ti layer 50 between layers 37 and 34. With this structure, the Ti layer 50 prevents the diffusion of N from TiN layer 34 into Aℓ alloy layer 37 (or Aℓ layer 36). Ti diffuses from the Ti layer into layer 37 (or layer 36), thus preventing Aℓ hillocks.

In the above embodiments, Ar was ion-implanted in layer 37. It is also possible, however, to ion-implant As, BF₂, or a mixture of the two.

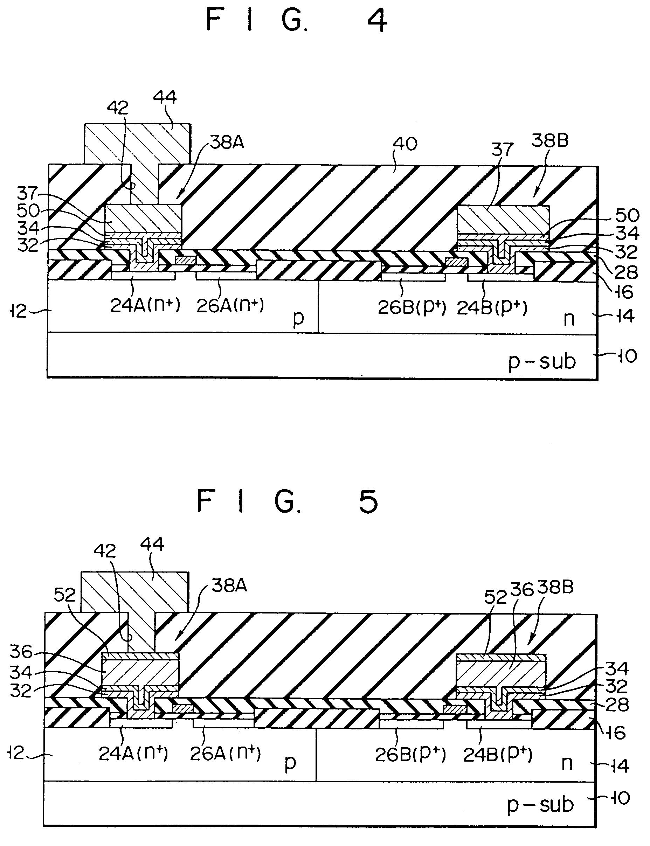

In the first embodiment described above, wiring electrodes 38A and 38B have a 3-layer structure formed of Aℓ, TiN and Ti layers 36, 34, and 32. However, the electrodes 38A, 38B may have a 4-layer structure in which a TiSi layer 52 is further formed on top of Aℓ layer 36 as shown in Fig. 5. The TiSi layer 52 blocks Aℓ hillocks with the stress corresponding to their growth and allows diffusion of Ti into the Aℓ or Aℓ allow layer, thereby preventing hillocks. This Ti also plays a large role in the control of electromigration. In the manufacture of the 4-layer structure, the Ti, TiN, Aℓ, and TiSi layers can all be deposited in the same vacuum.

## Claims

1. A semiconductor device comprising:
a semiconductor element (24A);
an insulating film (16, 18, 28) formed on said semiconductor element (24A), said insulating film (16, 18, 28) having a contact hole (30A) exposing a portion of said semiconductor element (24A); and
a wiring electrode (38A) connected to said semiconductor element (24A) through said contact hole (30A), said wiring electrode (38A) being composed of a first layer (32) of Ti formed on said insulating film (16, 18, 28) and the exposed portion of said semiconductor element (24A), a second layer (34) of TiN formed on said first layer (32), and a third layer (37) having Al as its major component and formed on said second layer (34);
characterized in that
said second layer (34) is in direct contact with a surface of said first layer (32) which is unexposed to atmospheric air.

2. A device according to claim 1, characterized in that said third layer (37) is made of one member selected from the group consisting of pure Al, an Al-Si alloy, an Al-Ti-Si alloy, and Al-Zr-Si alloy, an Al-Ti alloy and an Al-Zr alloy.

3. A device according to any preceding claim, characterized in that said wiring electrode further comprises a layer (52) of TiSi formed on said third layer (37).

4. A device according to any preceding claim, characterized in that said semiconductor element is a diffusion region of a first conductivity type formed in a semiconductor substrate (10) of a second conductivity type.

5. A device according to claim 4, characterized in that said third layer (37) has an amorphous surface region having at least one implanted impurity selected from the group consisting of As, BF₂ and Ar.

6. A device according to claim 5, characterized by further comprising:
a second insulating film (40) formed on said wiring electrode (38A) and having a second contact hole (42) exposing a portion of the amorphous surface region of said third layer (37); and
a wiring layer (44) formed on said second insulating film (40) and contacting the exposed portion of said third layer (37) through said second contact hole (42).

7. A device according to any preceding claim, characterized in that said third layer (37) has an amorphous surface region having at least one impurity selected from the group consisting of As, BF₂ and Ar.

8. A device according to claim 1, characterized by further comprising:
a second insulating film (40) formed on said wiring electrode (38A) and having a second contact hole (42) exposing a portion of a surface region of said third layer (37); and
a wiring layer (44) formed on said second insulating film (40) in contact with the surface region of said third layer (37) through said second contact hole (42).

9. A device according to claim 1, characterized in that said wiring electrode (38A) further comprises a fourth layer of Ti formed between said second layer (34) and said third layer (37).

10. A method of manufacturing a semiconductor device, said method comprising the steps of:
forming an insulating film (16, 18, 28) covering a surface of a silicon substrate (10);
forming a semiconductor element (24A) in the surface of said silicon substrate (10);
patterning said insulating film (16, 18, 28) to form a contact hole (30A) exposing a portion of said semiconductor element (24A);
depositing a first layer (32) of Ti on said insulating film (16, 18, 28) and the exposed portion of said semiconductor element (24A), and a second layer (34) of TiN on said first layer (32); and
depositing a third layer (37) having Al as its major component on said second layer (34), said first, second and third layers (32, 34, 37) forming an electrode for said semiconductor element (24A); characterized in that
said depositing step of the first and second layers (32, 34) includes a process of successively sputtering the first and second layers (32, 34) in a single vacuum chamber.

11. A method according to claim 10, characterized by further comprising the step of patterning said first, second and third layers (32, 34, 37) so that the remaining portions of said first, second and third layers (32, 34, 37) serve as a wiring layer.

12. A method according to claim 10, characterized by further comprising the step of forming an insulative, protective film (40) covering said wiring layer and the exposed portion of said insulating layer (16, 18, 28) by low-temperature plasma chemical vapour deposition.

13. A method according to claim 12, characterized in that said insulating layer (16, 18, 28) and said insulative, protective film (40) are composed of silicon oxide.

14. A method according to any of claims 10 to 13, characterized in that said semiconductor element (24A) is formed by doping an impurity in the surface of a silicon substrate (10).

15. A method according to claim 14, characterized in that said semiconductor element (24A) contains a p-type impurity.

16. A method according to any of claims 10 to 15, characterized in that said third layer (37) is formed of a material selected from the group consisting of pure Al, Al-Si alloys, Al-Ti-Si alloys, Al-Zr-Si alloys, Al-Ti alloys and Al-Zr alloys.

17. A method according to any of claims 10 to 16, characterized by further comprising the step of subjecting a surface of said third layer (37) to ion implantation of at least one impurity selected from the group consisting of As, BF₂ and Ar so that the surface of said third layer (37) becomes amorphous.

18. A method according to claim 10, characterized by further comprising a step of providing a fourth layer (50) of Ti between said second layer (34) and said third layer (37).

19. A method according to any of claims 10 to 18, characterized by further comprising a step of annealing said second layer (34) in a nitrogen atmosphere.

20. A semiconductor device with a wiring electrode, comprising:
a semiconductor element (24A, 24B);
an insulating film (18, 28) having a contact hole (30A, 30B) and formed on said semiconductor element (24A, 24B); and
a wiring electrode formed on said insulating film and connected to said semiconductor element through said contact hole characterized in that
said wiring electrode comprises a first layer (32) of Ti formed on said insulating film (18, 28) and an exposed portion of said semiconductor element (24A, 24B), a second layer (34) of TiN formed on said first layer (32), and a third layer (36) having Al as a major component and formed on said second layer (34).

21. A device according to claim 20, characterized in that said wiring electrode comprises first, second, and third layers (32, 34, 36) formed by deposition in the same vacuum.
